# EUROPÄISCHE PATENTSCHRIFT

(11) **EP 2 161 890 B1**
(45) Veröffentlichungstag und Bekanntmachung des Hinweises auf die Patenterteilung: **20.08.2014**
(21) Anmeldenummer: 09011249.1
(22) Anmeldetag: 02.09.2009
(51) Int. Cl.: H04L 25/02, H05K 1/02

(54) **Leiterplatine mit Terminierung einer T-förmigen Signalleitung**
Circuit board with termination of a T-shaped transmission line
Platine conductrice dotée d'une terminaison de ligne de transmission en forme de T.

(30) Priorität: 04.09.2008 DE 102008045707
(43) Veröffentlichungstag der Anmeldung: 10.03.2010
(73) Patentinhaber: Micronas GmbH, 79108 Freiburg (DE)
(72) Erfinder: Flamm, Peter, 79232 March (DE)
(74) Vertreter: Koch Müller Patentanwaltsgesellschaft mbH

(56) Entgegenhaltungen:
- US-A1- 2003 001 610
- ETHIRAJAN K ET AL: "TERMINATION TECHNIQUES FOR HIGH-SPEED BUSES", EDN ELECTRICAL DESIGN NEWS.(TEXAS INSTRUMENT), REED BUSINESS INFORMATION, HIGHLANDS RANCH, CO, US, Bd. 43, Nr. 4, 16. Februar 1998 (1998-02-16), Seite 135, XP000778427, ISSN: 0012-7515

## Beschreibung

Die Erfindung betrifft eine Leiterplatine mit Terminierung einer T-förmigen Signalleitung gemäß Oberbegriff des Patentanspruchs 1.

Viele elektronische Systeme, wie Computersysteme, Steuereinheiten oder Steuervorrichtungen bestehen aus einer Vielzahl von integrierten Schaltungen (IC), wie Mikroprozessoren oder Controller sowie davon gesteuerten Speichereinheiten, bspw. Schreib-/Lesespeicher (RAM), die auf einer Leiterplatine angeordnet sind und über auf der Leiterplatine angeordneten Signalleitungen miteinander kommunizieren.

Mit zunehmend hohen Arbeitsgeschwindigkeiten der integrierten Schaltungen (IC) ist es erforderlich auch mit einer hohen Datenübertragungsrate zwischen den integrierten Schaltungen über die Signalleitungen auf der Leiterplatine zu kommunizieren.

Um eine elektrische Kommunikation mit hoher Geschwindigkeit, d. h. die Signalübertragung erfolgt mit hohen Frequenzen bzw. mit steilen Flanken, zu ermöglichen, müssen die Signalleitungen auf der Leiterplatte eine definierte Impedanz aufweisen, damit Signalreflexionen auf den Leitungen vermieden werden. Dies wird in bekannter Weise durch einen Abschluss (Terminierung) der Signalleitungen mittels Terminierungs- bzw. Abschlusswiderständen erzielt, wodurch die durch Signalreflexionen verursachten Probleme verringert oder beseitigt werden. Der Abschluss bzw. die Terminierung von Signalleitungen kann als serielle, d. h. am Leitungsanfang, oder als parallele Terminierung, d. h. am Leitungsende, durchgeführt werden. Im Folgenden wird lediglich die parallele Terminierung behandelt.

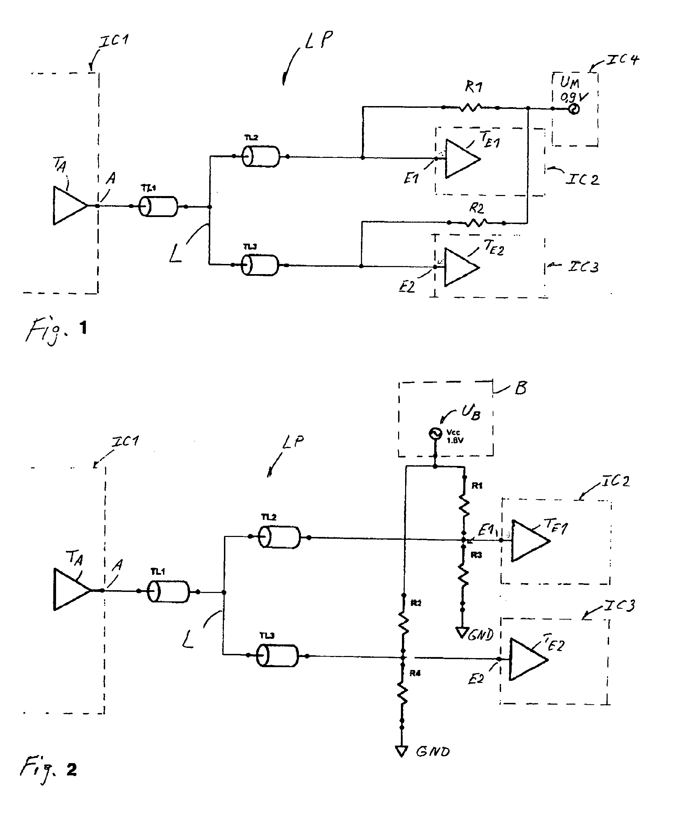

Figur 1 zeigt eine Leiterplatine LP mit einer bekannten Terminierung einer T-förmigen Signalleitung L zwischen dem Ausgang A eines Treibers T_{A} (Ausgangstreiber) einer integrierten Schaltung IC1, beispielsweise einer Steuereinheit, wie Mikroprozessor oder Controller und jeweils einem Eingang E1 und E2 von Eingangstreiber T_{E1} und T_{E2} weiterer integrierten Schaltungen IC2 und IC3, beispielsweise Speichereinheiten, wie Lese-Schreib-Speicher (RAM). Im Falle von RAM's stellen diese Eingänge E1 und E2 bspw. Adresseingänge von DRAM's dar und werden von dem Treiber T_{A1} der integrierten Schaltung IC1 versorgt.

Die T-förmige Signalleitung L besteht aus einer Leiterbahn TL1, die sich in eine Leiterbahn TL2 und hierzu parallel in eine Leiterbahn TL2 verzweigt, deren Leitungsenden mit dem Eingang E1 bzw. E2 verbunden sind. Die Leiterbahn TL1 hat einen Widerstand von z. B. 46Ω, die Leiterbahnen TL2 und TL3 jeweils einen Widerstand von z.B. 64,2Ω. Allerdings sind diese Widerstandswerte lediglich ein Beispiel und können auch andere Werte annehmen.

An jedem Leitungsende der T-förmigen Signalleitung L wird ein Terminierungswiderstand R1 und R2 gegen eine Mittenspannung U_{M} geschaltet. Bei einer Versorgungsspannung von 1,8V für die beiden integrierten Schaltungen IC2 und IC3 (DDR2 RAMs) beträgt diese Mittenspannung 0,9V und wird von einer zusätzlichen integrierten Schaltung IC4 aus der Versorgungsspannung der beiden integrierten Schaltungen IC2 und IC3 erzeugt. Dieser zusätzliche IC4 hält die Spannung auch bei größeren Strömen stabil und arbeitet sowohl als Strom-Quelle als auch als Strom-Senke. Der Wert der Terminierungswiderstände R1 und R2 hängt von der Leitungsimpedanz ab und kann z.B. 75Ω betragen.

Nachteilig an dieser bekannten Terminierung nach Figur 1 ist der hohe Aufwand durch die zusätzliche integrierte Schaltung IC4, der hierfür erforderliche Bauraum auf der Leiterplatine LP und die hierdurch bedingten hohen Herstellungskosten.

Eine weitere bekannte Terminierung zeigt Figur 2, welche ohne die aus Figur 1 bekannte zusätzliche integrierte Schaltung IC4 zur Erzeugung der Terminierungsspannung U_{M} von 0,9V auskommt.

Nach Figur 2 wird die Terminierungsspannung von 0,9V von je einem Spannungsteiler aus einer Versorgungsspannung UB von 1,8V der beiden integrierten Schaltungen IC2 und IC3 erzeugt. Für .die Terminierung des am Eingang E1 angeschlossenen Leitungsendes besteht der Spannungsteiler aus Widerständen R1 und R3, die jeweils den doppelten Wert des Terminierungswiderstandes nach Figur 1 aufweisen. Ein entsprechender Spannungsteiler aus Widerständen R2 und R4 bildet die Terminierung des am Eingang E2 liegenden Leitungsendes mit ebenfalls jeweils dem doppelten Wert. Die beiden Spannungsteiler R1/R3 und R2/R4 sind zwischen der Versorgungsspannung UB und dem Bezugspotential bzw. Masse GND der beiden integrierten Schaltungen IC2 und IC3 eingeschleift.

Diese bekannte Terminierung nach Figur 2 kommt wohl ohne den Zusatz-1C 4 gemäß Figur 1 aus, jedoch sind doppelt soviel Widerstände wie nach Figur 1 erforderlich, wodurch ebenso hohe Kosten durch die zusätzlichen Widerstände und den zusätzlich erforderlichen Bauraum anfallen.

Aus der US 2003 / 001610 A1 und aus Ethirajan K et al: "Termination techniques for High Speed Buses" EDN Electrical Design News. (Texas Instrument), REED Business Infrmation, Highlands Ranch, Co, Us, Bd. 43, Nr.4, 16. Februar 1998, Seite 135, ISSN: 0012-7515 sind weitere Terminierungen bekannt.

Aufgabe der Erfindung ist es, für den Ausgang einer integrier ten Schaltung, die mit einem Ausgangstreiber über eine T-förmige Signalleitung Eingänge von zwei weiteren integrierten Schaltungen treibt, eine einfache und kostengünstige Terminierung der Leitungsenden der T-förmigen Signalleitung anzugeben.

Diese Aufgabe wird gelöst durch eine asymmetrische Terminierung mit den Merkmalen des Patentanspruchs 1.

Bei dieser asymmetrischen Terminierung einer T-förmigen Signalleitung terminieren die Abschlusswiderstände nicht mehr gegen die Mittenspannung der Versorgungsspannung der an die Leitungsenden angeschlossenen integrierten Schaltungen, sondern an einem Leitungsende gegen diese Versorgungsspannung und am anderen Leitungsende gegen das Bezugspotential (Masse) der Versorgungsspannung.

Vorteilhafterweise entfällt mit der erfindungsgemäßen Terminierung die im Stand der Technik gemäß Figur 1 zusätzlich erforderliche integrierte Schaltung zur Erzeugung der Mittenspannung bzw. die Hälfte der im Stand der Technik gemäß Figur 2 erforderlichen Terminierungswiderstände. Insgesamt wird somit Bauraum auf der Leiterplatine eingespart, wodurch letztendlich auch die Herstellkosten reduziert werden können.

In einer Weiterbildung der Erfindung kann die erfindungsgemäße Terminierung auch auf T-förmige Signalleitungen mit mehr als zwei Leitungsenden angewendet werden, wenn diese zusätzlich 2n (n≥1, nε N) Leitungsenden aufweist, die jeweils mit Eingängen weiterer integrierten Schaltungen verbunden werden. Zur Terminierung werden 2n/2 der Leitungsenden ebenfalls gegen die Versorgungsspannung, während die anderen 2n/2 Leitungsenden gegen das Bezugspotential (Masse) der Versorgungsspannung terminiert werden. Vorzugsweise werden Terminierungswiderstände mit identischen Widerstandswerten verwendet, wobei die Terminierungsspannung vorzugsweise 50% der Versorgungsspannung der an die Leitungsenden angeschlossenen integrierten Schaltungen beträgt.

In einer Weiterbildung der Erfindung werden für die an die Leitungsenden der T-förmigen Signalleitung angeschlossenen integrierten Schaltungen Speicherbausteine, insbesondere Schreib-/Lesespeicher (RAM) mit jeweils einem Eingangstreiber eingesetzt, wobei die Eingangstreiber vorzugsweise Adresse, Kontroll und Clock-Eingänge der RAM's darstellen.

Die Erfindung wird nachfolgend anhand von Ausführungsbeispielen unter Bezugnahme auf die beigefügten Figuren ausführlich beschrieben. Es zeigen:
- Figur 1: ein Schaltbild mit einer Terminierung einer T-förmigen Signalleitung mit zwei Leitungsenden gemäß dem Stand der Technik,
- Figur 2: ein Schaltbild mit einer Terminierung einer T-förmigen Signalleitung mit zwei Leitungsenden gemäß einem weiteren Stand der Technik,
- Figur 3: ein Schaltbild mit einer erfindungsgemäßen Terminierung einer T-förmigen Signalleitung mit zwei Leitungsenden, und
- Figur 4: ein Schaltbild mit einer erfindungsgemäßen Terminierung einer T-förmigen Signalleitung mit mehr als zwei Leitungsenden.

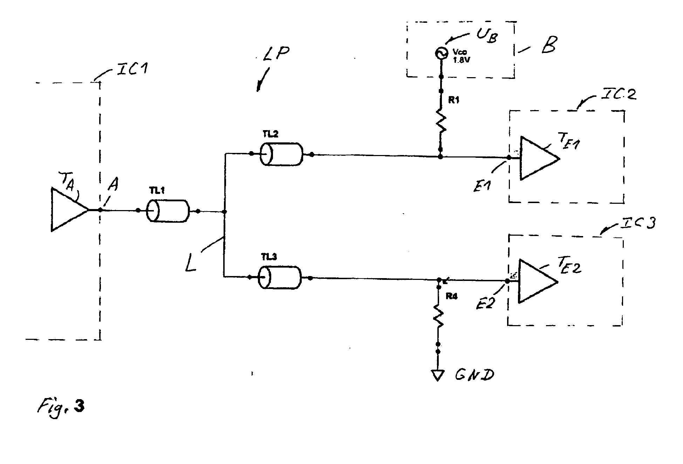

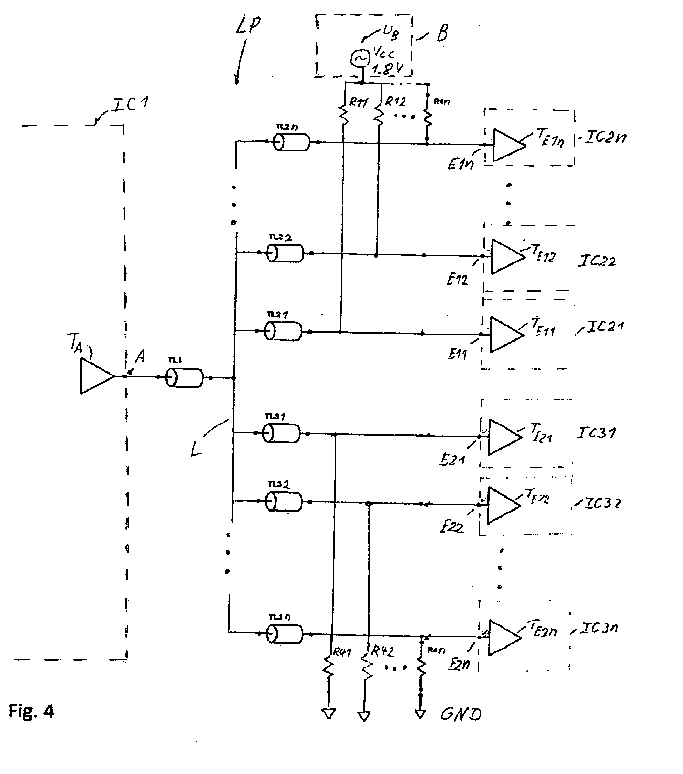

Die Figuren 1 und 2 wurden bereits in der Einleitung zur Darstellung des Standes der Technik beschrieben und erläutert und zeigen jeweils eine bekannte Terminierung einer T-förmigen Signalleitung L mit zwei Leitungsenden, die jeweils an einen Eingang E1 bzw. E2 von Eingangstreibern T_{E1} und T_{E2} einer integrierten Schaltung IC2 bzw. IC3 angeschlossen sind. Über diese T-förmige Signalleitung L steuert ein Ausgangstreiber TA einer integrierten Schaltung IC1 die beiden Eingänge E1 bzw. E2 der integrierten Schaltungen IC2 und IC3. Bis auf die Art und Weise der Terminierung ist diese Struktur identisch mit den in den Figuren 3 und 4 dargestellten Ausführungsbeispielen der Erfindung und daher wird zur Vermeidung von Wiederholungen im Folgenden lediglich die erfindungsgemäße Terminierung erläutert und beschrieben.

Nach Figur 3 wird zur Terminierung des an den Eingang E1 der zweiten integrierten Schaltung IC2 angeschlossenen Leitungsendes der T-förmigen Signalleitung L ein erster Abschlusswiderstand R1 gegen die Versorgungsspannung UB geschaltet und ein zweiter Abschlusswiderstand R4 zur Terminierung des an den Eingang E2 der dritten integrierten Schaltung IC3 angeschlossenen Leitungsendes mit dem Bezugspotential GND der Versorgungsspannung bzw. Masse GND verbunden. Dabei wird die Terminierungsspannung von 0,9V (bei einer Versorgungsspannung UB von 1,8V) von durch den jeweiligen Abschlusswiderstände R1 bzw. R4 und der niederohmigen Leitung gebildeten Spannungsteiler erzeugt. Die Abschlusswiderstände weisen einen Widerstandswert auf, der durch die Leitungsimpedanz bestimmt wird und z.B. 75Ω betragen kann.

Für die Erzeugung der Versorgungsspannung U_{B} werden Mittel B eingesetzt, in der Regel ein Netzteil; dies kann auch eine externe Erzeugung dieser Versorgungsspannung U_{B} umfassen.

Gegenüber dem Stand der Technik nach den Figuren 1 und 2 entfällt die zusätzliche integrierte Schaltung zur Erzeugung der Mittenspannung von 0,9V sowie die Hälfte der Abschlusswiderstände, wodurch erheblich Bauraum auf der Leiterplatte eingespart wird und sich dadurch die Herstellkosten einer solchen Leiterplatte erheblich reduzieren lassen.

Die erfindungsgemäße Terminierung nach Figur 3 lässt sich für alle Leiterplatinen mit einer integrierten Schaltung einsetzen, die mit einem Ausgangstreiber zwei Eingänge weiterer integrierter Schaltungen über eine T-förmige Struktur einer Signalleitung treibt und dabei die Leitungsenden gemäß der Erfindung terminiert werden, wobei die weiteren integrierten Schaltungen vorzugsweise Schreib-Lese-Speicher, insbesondere RAM's mit Adress, Kontroll und Clock-Eingängen darstellen.

Die erfindungsgemäße Terminierung kann auch für T-förmige Signalleitungen mit mehr als zwei Leitungsenden benutzt werden, nämlich mit 2n Leitungsenden für ein bestimmtes nεN mit n>1, wie im Folgenden anhand von Figur 4 erläutert wird.

Der Unterschied zu Figur 3 besteht darin, dass sich eine Leitungsbahn TL1 einer T-förmigen Signalleitung L, deren Leitungsanfang mit einem Ausgang A eines Ausgangstreibers TA einer integrierten Schaltung IC1 verbunden ist, sich nicht nur in zwei Leitungsbahnen TL2 und TL3 verzweigt, sondern einerseits in ein erstes Bündel von Leitungsbahnen TL21, TL22, ... und TL2n (n>1, nEN), deren Leitungsenden mit Eingängen E11, E12, ... und E1n (n>1, neN)von Eingangstreibern T_{E11}, T_{E12},... und T_{E1n} (n>1, nεN) einer ersten Gruppe von integrierten Schaltungen IC21, IC22,... und IC2n (n>1, nεN) verbunden sind, und andererseits in eine zweites Bündel von Leitungsbahnen TL31, TL32,... und TL3n (n>1, nεN), deren Leitungsenden mit Eingängen E21, E22, ... und E2n (n>1, nεN) von Eingangstreibern T_{E21}, T_{E22},... und T_{E2n} (n>1, nεN) einer zweiten Gruppe von integrierten Schaltungen IC31, IC32,... und IC3n (n>1, nεN) verbunden sind.

Die Terminierung der Leitungsenden der Leitungsbahnen TL21, TL22, ... und TL2n des ersten Bündels erfolgt entsprechend der Terminierung nach Figur 3 mit jeweils einem mit der Versorgungsspannung U_{B} verbundenen Abschlusswiderstand R11, R12,... und R1n (n>1, nεN), während die Terminierung der Leitungsenden des zweiten Bündels von Leitungsbahnen TL31, TL32,... und TL3n (n>1, nεN) entsprechend der Terminierung nach Figur 3 mit gegen das Bezugspotential bzw. Masse GND geschalteten Abschlusswiderständen R41, R42,... und R4n (n>1, nεN) erfolgt. Die Abschlusswiderstände R11, R12,... und R1n sowie R41, R42,... und R4n weisen jeweils einen Widerstandswert auf, der von der Leitungsimpedanz bestimmt wird und z.B. 75Ω betragen kann.

Auch bei dieser T-förmigen Signalleitung L mit 2n (n>1, nεN) Leitungsenden wird die Terminierungsspannung von 0,9V von Spannungsteilern erzeugt, die einerseits jeweils aus den gegen die Versorgungsspannung UB geschalteten Abschlusswiderständen R11, R12,... und R1n (n>1, nεN) und den niederohmigen Leitungsbahnen und andererseits jeweils aus den gegen die Bezugsspannung bzw. Masse GND geschalteten Abschlusswiderständen R41, R42,... und R4n (n>1, nεN) und ebenfalls den niederohmigen Leitungsbahnen gebildet werden.

Die Versorgungsspannung U_{B} wird in gleicher Weise wie nach Figur 3 erzeugt, indem Mittel B eingesetzt werden, die in der Regel ein Netzteil darstellen; dies kann eine externe Erzeugung dieser Versorgungsspannung UB ebenfalls umfassen.

Die erfindungsgemäße Terminierung nach Figur 4 lässt sich für alle Leiterplatinen mit einer integrierten Schaltung einsetzen, die mit einem Ausgangstreiber mehr als zwei Eingänge weiterer integrierter Schaltungen über eine T-förmige Struktur einer Signalleitung mit entsprechender Anzahl von Leitungsenden treibt und diese dabei terminiert werden, wobei die weiteren integrierten Schaltungen vorzugsweise Schreib-Lese-Speicher, insbesondere RAM's mit Adress, Kontroll und Clock-Eingängen darstellen.

### Bezugszeichenliste

- A: Datenausgang
- B: Mittel zur Erzeugung einer Versorgungsspannung U_{B}

- E1, E2: Dateneingänge
- E11, E12, ... E1n: Dateneingänge
- E21, E22, ... E2n: Dateneingänge

### GND Bezugspotential (Masse)

- IC1, IC2, IC3, IC4: Integrierte Schaltungen (IC)
- IC21, IC22, ... IC2n: Integrierte Schaltungen (IC)
- IC31, IC32, ... IC3n: Integrierte Schaltungen (IC)

- L: T-förmige Signalleitung
- LP: Leiterplatine

- R2, R2: Abschlusswiderstände
- R11, R12, ... R1n: Abschlusswiderstände
- R41, R42, ... R4n: Abschlusswiderstände

- T_{A}: Ausgangstreiber
- T_{E1}, T_{E2}: Eingangstreiber
- T_{E11}, T_{E12}, ... T_{E1n}: Eingangstreiber
- T_{E21}, T_{E22}, ... T_{E2n}: Eingangstreiber

- TL1, TL2, TL3: Leiterbahnen
- TL21, TL22, ... TL2n: Leiterbahnen
- TL31, TL32, ... TL3n: Leiterbahnen

- U_{B}: Versorgungsspannung
- U_{M}: Mittenspannung

## Patentansprüche

1. Leiterplatine (LP) mit Terminierung einer T-förmigen Signalleitung (L), umfassend:
- eine erste integrierte Schaltung (IC1) mit wenigstens einem Datenausgang (A),
- wenigstens eine zweite und dritte integrierte Schaltung (IC2, IC3) mit jeweils einem Dateneingang (E1, E2) und Schaltungsmittel (B) zur Erzeugung einer Versorgungsspannung (UB) gegen ein Bezugspotential (GND) für die zweite und dritte integrierte Schaltung (IC2, IC3),
- einen Leitungsanfang der T-förmigen Signalleitung (L), der mit dem Datenausgang (A) der ersten integrierten Schaltung (IC1) verbundenen ist,
- wenigstens zwei Leitungsenden der T-förmigen Signalleitung (L), die jeweils mit einem Dateneingang (E1, E2) der zweiten bzw. dritten integrierten Schaltung (IC2, IC3) verbunden sind, und
- einen jeweils das Leitungsende am Dateneingang (E1, E2) der zweiten bzw. dritten integrierten Schaltung (IC2, IC3) terminierenden ersten bzw. zweiten Abschlusswiderstand (R1, R4)
**dadurch gekennzeichnet, dass**
der erste Abschlusswiderstand (R1) gegen die Versorgungsspannung (U_{B}) terminiert ist und der erste Abschlusswiderstand (R1) mit dem ersten Leitungsende und dem Dateneingang (E1) der zweiten integrierten Schaltung (IC2) verbunden ist und dass der zweite Abschlusswiderstand (R4) gegen das Bezugspotential (GND) terminiert ist und der zweite Abschlusswiderstand (R4) mit dem zweiten Leitungsende und dem Dateneingang (E2) der dritten integrierten Schaltung (IC3) verbunden ist, wobei die beiden Abschlusswiderstände (R1, R4) einen Spannungsteiler bilden und die Terminierungsspannung erzeugen .

2. Leiterplatine nach Anspruch 1, **dadurch gekennzeichnet, dass** die T-förmige Signalleitung (L) weitere 2n (n≥11, nεN) Leitungsenden aufweist, die jeweils mit Eingängen (E11, E12, ...; E21, E22, ...) weiterer integrierten Schaltungen (IC21, IC22, ...; IC31, IC32, ...,) verbunden sind und die weiteren Leitungsenden mit ersten bzw. zweiten Abschlusswiderständen (R11, R12, ...; R41, R42,...) terminiert sind und dass die ersten Abschlusswiderstände (R11, R12,...) gegen die Versorgungsspannung (UB) und die zweiten Abschlusswiderstände (R41, R42, ...) gegen das Bezugspotential (GND) terminiert sind.

3. Leiterplatine nach Anspruch 1 oder 2, **dadurch gekennzeichnet, dass** der erste Abschlusswiderstand (R1) bzw. die ersten Abschlusswiderstände (R11, R12, ...) und der zweite Abschlusswiderstand (R4) bzw. die zweiten Abschlusswiderstände (R41, R42,...) die gleichen Widerstandswerte aufweisen.

4. Leiterplatine nach einem der vorangehenden Ansprüche, **dadurch gekennzeichnet, dass** der Wert der Terminierungsspannung 50% der Versorgungsspannung (UB) beträgt.

5. Leiterplatine nach einem der vorangehenden Ansprüche, **dadurch gekennzeichnet, dass** die zweite und dritte integrierte Schaltung (IC2, IC3) bzw. die weiteren integrierten Schaltungen (IC21, IC22,...; IC31, IC32,...) Speicherbausteine, insbesondere Schreib-Lese-Speicher (RAM) mit jeweils einem Eingangstreiber (T_{E1}, TE₁₁; T_{E2}, T_{E21}, T_{E22}) umfassen, wobei die Eingangstreiber (T_{E1}, TE₁₁; T_{E2}, T_{E21}, T_{E22}) vorzugsweise Adress, Kontroll oder Clock-Eingänge darstellen.

## Claims

1. Circuitboard (LP) with termination of a T-shaped signal line (L), comprising:
- a first integrated circuit (IC1) with at least one data output (A),
- at least one second and third integrated circuit (IC2, IC3) each with a data input (E1, E2) and switching means (B) for generating a supply voltage (UB) relative to a reference potential (GND) for the second and third integrated circuits (IC2, IC3),
- a line start of the T-shaped signal line (L), which is connected with the data output (A) of the first integrated circuit (IC1),
- at least two line ends of the T-shaped signal line (L), which are each connected with a data input (E1, E2) at the respective one of the second and third integrated circuits (IC2, IC3) and
- a first and a second terminating resistance (R1, R4) each terminating the line end at the data input (E1, E2) of a respective one of the second and third integrated circuits (IC2, IC3),
**characterised in that**
the first terminating resistance (R1) is terminated relative to the supply voltage (Uₛ) and the first terminating resistance (R1) is connected with the first line end and the data input (E1) of the second integrated circuit (IC2) and that the second terminating resistance (R4) is terminated relative to the reference potential (GND) and the second terminating resistance (R4) is connected with the second line end and the data input (E2) of the third integrated circuit (IC3), wherein the two terminating resistances (R1, R4) form a voltage divider and produce the terminating voltage.

2. Circuitboard according to claim 1, **characterised in that** the T-shaped signal line (L) further comprises 2n (n ≥ 11, nεN) line ends, which are respectively connected with inputs (E11, E12 ...; E21, E22 ...) of further integrated circuits (IC21, IC22 ...; IC31, IC32 ...) and the further line ends are terminated by first and second terminating resistances (R11, R12 . R41, R42 ...) and that the first terminating resistances (R11, R12 ...) are terminated relative to the supply voltage (UB) and the second terminating resistances (R41, R42 ...) are terminated relative to the reference potential (GND).

3. Circuitboard according to claim 1 or 2, **characterised in that** the first terminating resistance (R1) or the first terminating resistances (R11, R12 ...) and the second terminating resistance (R4) or the second terminating resistances (R41, R41 ...) have the same resistance values.

4. Circuitboard according to any one of the preceding claims, **characterised in that** the value of the terminating voltage is 50% of the supply voltage (UB).

5. Circuitboard according to any one of the preceding claims, **characterised in that** the second and third integrated circuits (IC2, EC3) or the further integrated circuits (IC21, IC22 ...; IC31, IC32 ...) comprise memory modules, particularly write/read memories (RAM) each with a respective input driver (T_{E1}, TE₁₁; T_{E2}, T_{E21}, T_{E22}), wherein the input drivers (T_{E1}, TE₁₁; T_{E2}, T_{E21}, T_{E22}) preferably represent address, control or clock inputs.

## Revendications

1. Platine conductrice (LP) dotée d'une terminaison de ligne de transmission en forme de T (L), comprenant :
- un premier circuit intégré (ICI) comportant au moins une sortie de données (A),
- au moins un deuxième et un troisième circuits intégrés (IC2, IC3) comportant respectivement une entrée de données (E1, E2) et des moyens de couplage (B) pour la production d'une tension d'alimentation (U_{B}) par rapport à un potentiel de référence (GND) pour le deuxième et le troisième circuits intégrés (IC2, IC3),
- un début de ligne de la ligne de transmission en forme de T (L), qui est relié à la sortie de données (A) du premier circuit intégré (ICI),
- au moins deux fins de ligne de la ligne de transmission en forme de T (L), qui sont respectivement reliées à une entrée de données (E1, E2) du deuxième ou du troisième circuit intégré (IC2, IC3), et
- une première ou une deuxième résistance terminale (R1, R4) terminant respectivement la fin de ligne à l'entrée de données (E1, E2) du deuxième ou du troisième circuit intégré (IC2, IC3), et
**caractérisée en ce que** la première résistance terminale (R1) est terminée par rapport à la tension d'alimentation (U_{B}) et la première résistance terminale (R1) est reliée à la première fin de ligne et à l'entrée de données (E1) du deuxième circuit intégré (IC2) et **en ce que** la deuxième résistance terminale (R4) est terminée par rapport au potentiel de référence (GND) et la deuxième résistance terminale (R4) est reliée à la deuxième fin de ligne et à l'entrée de données (E2) du troisième circuit intégré (IC3), les deux résistances terminales (R1, R4) formant un diviseur de tension et produisant la tension de terminaison.

2. Platine conductrice selon la revendication 1, **caractérisée en ce que** la ligne de transmission en forme de T (L) présente 2n autres fins de ligne (n≥11, n∈N), qui sont respectivement reliées à des entrées (E11, E12, ... ; E21, E22, ...) d'autres circuits intégrés (IC21, IC22, ... ; IC31, IC32, ...) et les autres fins de ligne sont terminées avec des premières ou deuxièmes résistances terminales (R11, R12, ... ; R41, R42, ...) et **en ce que** les premières résistances terminales (R11, R12, ...) sont terminées par rapport à la tension d'alimentation (U_{B}) et les deuxièmes résistances terminales (R41, R42, ...) sont terminées par rapport au potentiel de référence (GND).

3. Platine conductrice selon la revendication 1 ou 2, **caractérisée en ce que** la première résistance terminale (R1) ou les premières résistances tenninales (R11 R12, ...) et la deuxième résistance terminale (R4) ou les deuxièmes résistances terminales (R41, R42, ...) présentent des valeurs de résistance égales.

4. Platine conductrice selon l'une quelconque des revendications précédentes, **caractérisée en ce que** la valeur de la tension de terminaison vaut 50 % de la tension d'alimentation (U_{B}).

5. Platine conductrice selon l'une quelconque des revendications précédentes, **caractérisée en ce que** le deuxième et le troisième circuits intégrés (IC2, IC3) ou les autres circuits intégrés (IC21, IC22, ... ; IC31, IC32, ...) comprennent des modules de mémoire, en particulier de mémoire d'écriture-lecture (RAM) respectivement avec un pilote d'entrée (T_{E1}, T_{E11} ; T_{E2}, T_{E21}, T_{E22}), les pilotes d'entrée (T_{E1}, T_{E11}; T_{E2}, T_{E21}, T_{E22}) représentant de préférence des entrées d'adresse, de contrôle ou d'horloge.
